# EUROPEAN PATENT APPLICATION

(11) **EP 4 787 215 A1**
(43) Date of publication of application: **05.08.2026**
(21) Application number: 25179694.2
(22) Date of filing: 29.05.2025
(51) Int. Cl.: G06F 30/12, G06F 30/27, G06N 3/08

(54) **METHOD AND SYSTEM FOR GENERATING 2D VIEWS OF 3D CAD MODELS**

(30) Priority: 04.02.2025 IN 202541009635
(71) Applicant: L & T Technology Services Limited, Chennai 600089 (IN)
(72) Inventor: SANTHIYA, RAJAN, 641045 Coimbatore (IN); VIVEKANANDAN, DHANABALOU, 605004 Puducherry (IN); SURESH, GUNASEKARAN, 632301 Tiruvannamalai (IN); BASHA, MOHAMED, 600119 Chennai (IN)
(74) Representative: Studio Torta S.p.A.

(57) **Abstract**

This disclosure relates to method and system for generating 2D views of 3D CAD models. The method may include receiving a 3D CAD model in B-rep form and a user selection corresponding to one or more 2D views of the 3D CAD model. The method may further include creating a prompt based on the 3D CAD model and the user selection. The prompt may include the 3D CAD model and predefined instructions corresponding to the one or more 2D views to be generated. The method may further include inputting the prompt to an optimized and compressed domain adapted task down streamed LLM. The optimized and compressed domain adapted task down streamed LLM is obtained through multi-stage pre-training of a foundation LLM. The method may further include generating a 2D CAD model in B-rep form corresponding to each of the one or more 2D views of the 3D CAD model.

## Description

### TECHINAL FIELD

This disclosure relates generally to the field of Computer Aided Drawing (CAD) and more particularly to the method and system for generating 2D views of 3D CAD models.

### BACKGROUND

In the domain of engineering drawings, the conversion of 3D models to various 2D views (i.e., orthographic projections) remains a fundamental problem. In the present state of art, CAD drawing tools include in-built functionalities which may generate the 2D views of 3D models. However, the 2D views generated by the conventional CAD drawing tools may be subject to numerous challenges, for example, improper dimensioning of the 2D views, less hygiene of generated dimensions, transfer of a 2D view between different sheets, and positioning of different 2D views within a single sheet. Thus, conventional techniques for 2D view generation are inefficient and time consuming, particularly for complex 3D designs.

There is, therefore, a need in the present state of art for techniques for accurately and efficiently generating 2D views of 3D models.

### SUMMARY

In one embodiment, a method for generating 2-Dimensional (2D) views of 3-Dimensional (3D) Computer-Aided Design (CAD) models is disclosed. The method may include receiving a 3D CAD model in boundary representation (B-rep) form and a user selection corresponding to one or more 2D views of the 3D CAD model, via a user interface. The method may further include creating a prompt based on the 3D CAD model and the user selection. The prompt may include the 3D CAD model and predefined instructions corresponding to the one or more 2D views to be generated. The method may further include inputting the prompt to an optimized and compressed domain adapted task down streamed Large Language Model (LLM). The optimized and compressed domain adapted task down streamed LLM is obtained through multi-stage pre-training of a foundation LLM. The method may further include generating using the optimized and compressed domain adapted task down streamed LLM, a 2D CAD model in B-rep form corresponding to each of the one or more 2D views of the 3D CAD model, in response to the input prompt.

In one embodiment, a system for generating 2D views of 3D CAD model is disclosed. In one example, the system may include a processor and a memory communicatively coupled to the processor. The memory may store processor-executable instructions, which, on execution, may cause the processor to receive a 3D CAD model in B-rep form and a user selection corresponding to one or more 2D views of the 3D CAD model, via a user interface. The processor-executable instructions, on execution, may further cause the processor to create a prompt based on the 3D CAD model and the user selection. The prompt may include the 3D CAD model and predefined instructions corresponding to the one or more 2D views to be generated. The processor-executable instructions, on execution, may further cause the processor to input the prompt to an optimized and compressed domain adapted task down streamed LLM. The optimized and compressed domain adapted task down streamed LLM is obtained through multi-stage pre-training of a foundation LLM. The processor-executable instructions, on execution, may further cause the processor to generate using the optimized and compressed domain adapted task down streamed LLM, a 2D CAD model in B-rep form corresponding to each of the one or more 2D views of the 3D CAD model, in response to the input prompt.

### BRIEF DESCRIPTION OF THE DRAWINGS

**FIG. 1** is a block diagram of an exemplary system for generating 2D views of 3D CAD models, in accordance with some embodiments of the present disclosure.
**FIG. 2** illustrates a functional block diagram of various modules within a memory of a computing device configured to generate 2D views of 3D CAD models, in accordance with some embodiments of the present disclosure.
**FIG. 3** illustrates a flow chart of an exemplary process for generating 2D views of 3D CAD models, in accordance with some embodiments of the present disclosure.
**FIG. 4** illustrates a flow chart of a detailed exemplary process for generating 2D views of 3D CAD models, in accordance with some embodiments of the present disclosure.
**FIG. 5** illustrates a flow chart of an exemplary process for a multi-stage pre-training of the foundation LLM, in accordance with some embodiments of the present disclosure.
**FIG. 6** illustrates a flow chart of an exemplary process for preprocessing of a training data corpus, in accordance with some embodiments of the present disclosure.
**FIG. 7** illustrates a flow chart of various architectures of a foundation LLM, in accordance with some embodiments of the present disclosure.
**FIG. 8** illustrates a flow chart of exemplary process of model scaling of a foundation LLM, in accordance with some embodiments of the present disclosure.
**FIG. 9** is a schematic diagram of an exemplary process for generating 2D views of 3D CAD models, in accordance with some embodiments of the present disclosure.
**FIG. 10** is a block diagram of an exemplary computer system for implementing embodiments consistent with the present disclosure.

### DETAILED DESCRIPTION OF THE DRAWINGS

Exemplary embodiments are described with reference to the accompanying drawings. Wherever convenient, the same reference numbers are used throughout the drawings to refer to the same or like parts. While examples and features of disclosed principles are described herein, modifications, adaptations, and other implementations are possible without departing from the spirit and scope of the disclosed embodiments. It is intended that the following detailed description be considered as exemplary only, with the true scope and spirit being indicated by the following claims.

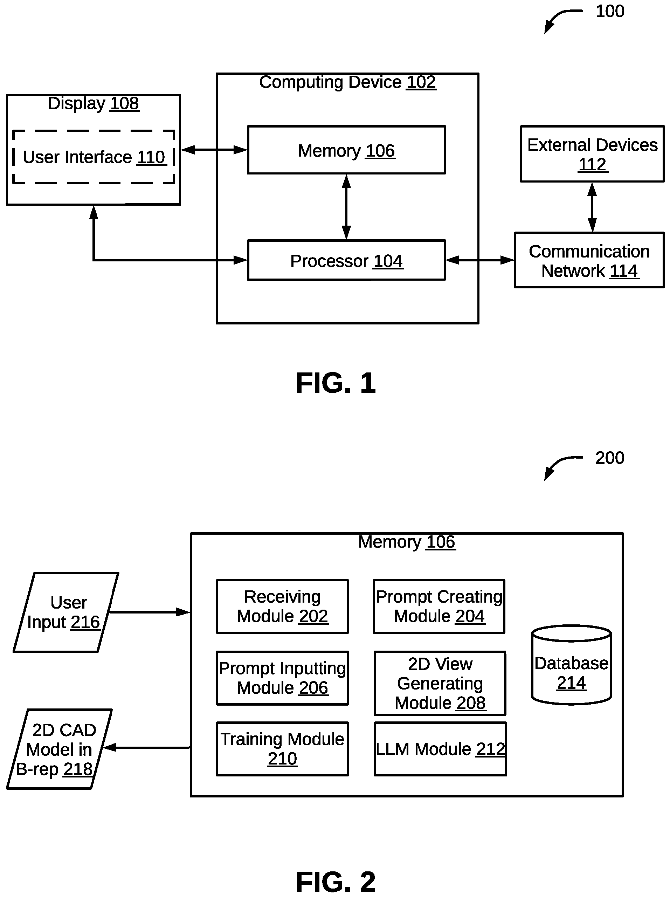

Referring now to **FIG. 1****,** a block diagram of an exemplary system 100 for generating 2-Dimensional (2D) views of 3-Dimensional (3D) Computer-Aided Design (CAD) models is illustrated, in accordance with some embodiments of the present disclosure. The 3D CAD models may be representations of the 3D objects. The 3D CAD models may be in boundary representation (B-rep) form. As will be appreciated, Boundary representation, also known as b-rep or surface modelling, is a method that involves representing an n-dimensional object through its (n - 1)-dimensional boundary. Most of the time this term is used in the context of 3D modelling, where the aim is to represent a 3D object implicitly through its 2D boundary. That being said, boundary representation is also common in 2D as well, where polygons are sometimes represented based on the line segments that bound them, and it is the main method used in 1D, where most of the time we represent line segments based on the two points that bound them. Boundary representation can thus be used several times when representing a single 3D model: to represent a 3D volume as a set of 2D surfaces, each 2D surface as a set of 1D line segments or curves, and each 1D line segment as a pair of 0D points-or often 2D polygonal surfaces directly as sequences of 0D points.

The system 100 may include a computing device 102 (for example, a server, a desktop, a laptop, a notebook, a netbook, a tablet, a smartphone, a mobile phone, or any other computing device). The computing device 102 may generate 2D views of 3D CAD models. It should be noted that, in some embodiments, the computing device 102 may generate 2D views of 3D CAD models in boundary representation (B-rep) form using an optimized and compressed domain adapted task down streamed Large Language Model (LLM). The 2D views may be orthographic projections of the 3D CAD models. Additionally, the computing device 102 may generate the 2D views in B-rep form (same data format as that of the input 3D CAD model).

As will be described in the greater detail in conjunction with FIGs. 2-9, the computing device 102 may receive a 3D CAD model in B-rep form by a user selection corresponding to one or more 2D views of the 3D CAD model. The computing device 102 may further create a prompt based on the 3D CAD model and the user selection. The prompt comprises the 3D CAD model and predefined instructions corresponding to the one or more 2D views to be generated. The computing device 102 may further input the prompt to an optimized and compressed domain adapted task down streamed LLM. The optimized and compressed domain adapted task down streamed LLM is obtained through multi-stage pre-training of a foundation LLM. The computing device 102 may further generate using the optimized and compressed domain adapted task down streamed LLM. A 2D CAD model in B-rep form corresponding to each of the one or more 2D views of the 3D CAD model, in response to the input prompt.

In some embodiment, the computing device 102 may include one or more processor(s) 104 and a memory 106. The memory 106 may store instructions that, when executed by the one or more processors 104, may cause the one or more processors 104 to generate 2D views of 3D CAD models, in accordance with aspects of the present disclosure. The memory 106 may also store various data (for example, a 3D CAD model in B-rep form, 2D views of the 3D CAD model, a prompt, a 2D CAD model in B-rep form and the like) that may be captured, processed, and/or required by the system 100.

The system 100 may further include a display 108. The system 100 may interact with a user via a user interface 110 accessible via the display 108. The system 100 may also include one or more external devices 112. In some embodiments, the computing device 102 may interact with the one or more external devices 112 over a communication network 114 for sending or receiving various data. The external devices 112 may include, but may not be limited to, a remote server, a digital device, or another computing system.

Referring now to FIG. 2, a functional block diagram of an exemplary system 200 for generating 2D views of 3D CAD models is illustrated, in accordance with some embodiments of the present disclosure. FIG. 2 is explained in conjunction with FIG. 1. The system 200 may include, within the memory 106, a receiving module 202, a prompt creating module 204, a prompt inputting module 206, a 2D view generating module 208, a training module 210, an LLM module 212, and a database 214. The memory 106 may store various data and immediate results generated by the modules 202-212. The LLM module 212 may include an LLM (not shown). The LLM may be an optimized and compressed domain adapted task down streamed LLM. By way of an example, the LLM may be, but may not be limited to, Generative Pre-trained Transformer (GPT)-3, GPT-3.5, GPT-4, Language Model for Dialogue Applications (LaMDA), Pathways Language Model (PaLM), Gemini, Claude, BigScience Large Open-science Open-access Multilingual Language Model (BLOOM), Large Language Model Meta AI (Llama), Mistral 7B, Mixtral 8x7B, Mixtral 8x22B, or the like.

The receiving module 202 may receive a user input 216 via a User Interface (such as the user interface 110). The user input 216 may include a 3D CAD model in B-rep form and a user selection corresponding to one or more 2D views of the 3D CAD model. In an embodiment, the user interface may render a plurality of options of 2D views. The user may then provide the user selection by selecting one or more of the plurality of options corresponding to the one or more 2D views. Further, the receiving module 202 may send the user input 216 to the prompt creating module 204.

Further, the prompt creating module 204 may create a prompt based on the 3D CAD model and the user selection. The prompt may include the 3D CAD model and predefined instructions corresponding to the one or more 2D views to be generated. The predefined instructions may correspond to a prompt template pre-stored in the database 214. By way of an example, the prompt template may be few shot, chain of thought, tree of thought, etc. An example of a structured organized prompt may be as follows.
"You are a mechanical engineer involved in the process of converting 3D CAD models to its equivalent 2D views using boundary representation. Complete this task based on below instructions for the attached 3D CAD model file
**Objective:** Generate accurate and well-organized 2D views from a provided 3D CAD model, ensuring proper dimensioning, cleanliness of dimensions, appropriate transfer between sheets, and optimal positioning within a single sheet.

### **Instructions:**

1. **Input Specifications:**
   - Provided the 3D CAD model file (in formats .STEP).
   - Selected 2D view to be converted from user interface (e.g., front, top, side, isometric).
2. **Dimensioning Guidelines:**
   - Ensure all dimensions are clearly defined and adhere to industry standards (e.g., ISO, ANSI).
   - Avoid overlapping dimensions; maintain a minimum spacing of [X units] between dimensions.
   - Use consistent dimension styles (e.g., arrowheads, text size) across all views.
3. **Hygiene of Dimensions:**
   - Ensure that all dimensions are legible and free from clutter.
   - Use a clean layout with sufficient white space around dimensions and annotations.
4. **Sheet Management:**
   - If transferring views between sheets, ensure that the scale and orientation remain consistent.
   - Clearly label each sheet with a title block that includes the project name, date, and view descriptions.
   - Maintain a logical flow of views across sheets, ensuring that related views are grouped together.
5. **Positioning of Views:**
   - Maintain a uniform margin of [Y units] around each view.
6. **Quality Assurance:**
   - Review the generated 2D views for accuracy against the original 3D model.
   - Ensure that all dimensions are correctly represented and that the layout adheres to the specified guidelines.

### **End of Prompt**"

To create the prompt, the prompt creating module 204 may retrieve the predefined instructions from the database 214. Further, the prompt creating module 204 may add the 3D CAD model and the user selection to the predefined instructions to obtain the prompt. Further, the prompt creating module 204 may send the prompt to the prompt inputting module 206. Further, the prompt inputting module 206 may send the prompt along with other necessary LLM hyperparameters (such as temperature, top k value, top p value, maximum tokens, frequency penalty, etc.) to the LLM module 212. The LLM module 212 may then input the prompt to the optimized and compressed domain adapted task down streamed LLM.

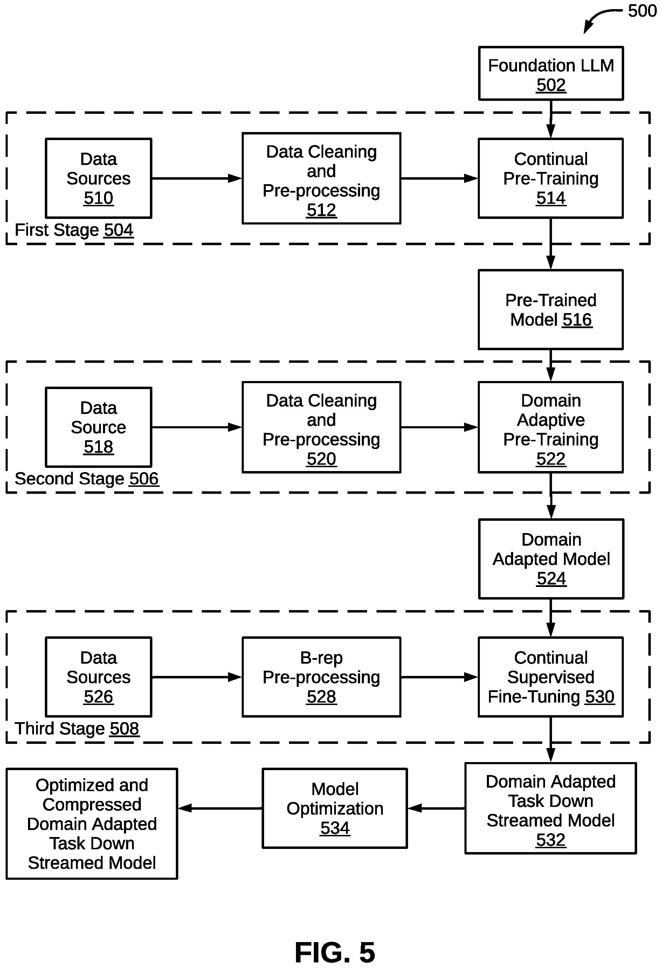

It should be noted that the optimized and compressed domain adapted task down streamed LLM is obtained through multi-stage pre-training of a foundation LLM. For the multi-stage pre-training, the training module 210 may perform a first stage continual pre-training on the foundation LLM to obtain a pre-trained LLM, a second stage pre-training on the pre-trained LLM to obtain a domain adapted LLM, and a third stage pre-training on the domain adapted LLM to obtain the domain adapted task down streamed LLM. At each of the three stages, a different training data corpus is used depending upon a training objective. The training module 210 may retrieve the training data corpus from the database 214. The training module 210 may then preprocess a training data corpus for each stage of the multi-stage pre-training, using a set of preprocessing techniques. The set of preprocessing techniques may include data deduplication, data cleaning, data decontamination, Personally Identifiable Information (PII) removal, data quality enhancement, bias reduction, and toxicity reduction. Further, the training module 210 may perform tokenization of the training data corpus using a tokenization technique, to obtain a tokenized training data corpus. Further, the training module 210 may transform the tokenized training data corpus to a plurality of packed token sequences. The process of multi-stage pre-training of the foundation LLM is further explained in greater detail in conjunction with FIGS. 5, 6, and 7.

Further, the LLM module 212 may generate a 2D CAD model in B-rep form 218 corresponding to each of the one or more 2D views of the 3D CAD model using the optimized and compressed domain adapted task down streamed LLM, in response to the input prompt. Further, the LLM module 212 may send the generated 2D CAD model in B-rep form 218 to the 2D view generating module 208. Further, the 2D view generating module 208 may render, on the user interface, the 2D CAD model in B-rep form 218 corresponding to each of the one or more 2D views of the 3D CAD model. In an embodiment, the 2D CAD model in B-rep form, 218, can further be imported by a CAD tool (e.g., freeCAD, AutoCAD, CREO, etc.) to visualize the 2D CAD model in B-rep form 218.

It should be noted that all such aforementioned modules 202 - 212 may be represented as a single module or a combination of different modules. Further, as will be appreciated by those skilled in the art, each of the modules 202 - 212 may reside, in whole or in parts, on one device or multiple devices in communication with each other. In some embodiments, each of the modules 202 - 212 may be implemented as dedicated hardware circuit comprising custom application-specific integrated circuit (ASIC) or gate arrays, off-the-shelf semiconductors such as logic chips, transistors, or other discrete components. Each of the modules 202 - 212 may also be implemented in a programmable hardware device such as a field programmable gate array (FPGA), programmable array logic, programmable logic device, and so forth. Alternatively, each of the modules 202 - 212 may be implemented in software for execution by various types of processors (e.g., processor 104). An identified module of executable code may, for instance, include one or more physical or logical blocks of computer instructions, which may, for instance, be organized as an object, procedure, function, or other construct. Nevertheless, the executables of an identified module or component need not be physically located together but may include disparate instructions stored in different locations which, when joined logically together, include the module and achieve the stated purpose of the module. Indeed, a module of executable code could be a single instruction, or many instructions, and may even be distributed over several different code segments, among different applications, and across several memory devices.

As will be appreciated by one skilled in the art, a variety of processes may be employed to generate 2D views of 3D CAD models by a computing device 102. For example, exemplary system 100 and the associated computing device 102 may generate 2D views of 3D CAD models by the processes discussed herein. In particular, as will be appreciated by those of ordinary skill in the art, control logic and/or automated routines for performing the techniques and steps described herein may be implemented by the system 100 and the associated computing device 102 either by hardware, software, or combinations of hardware and software. For example, suitable code may be accessed and executed by one or more processors on the system 100 to perform some or all the techniques described herein. Similarly, application specific integrated circuits (ASICs) configured to perform some, or all the processes described herein may be included in the one or more processors on the system 100.

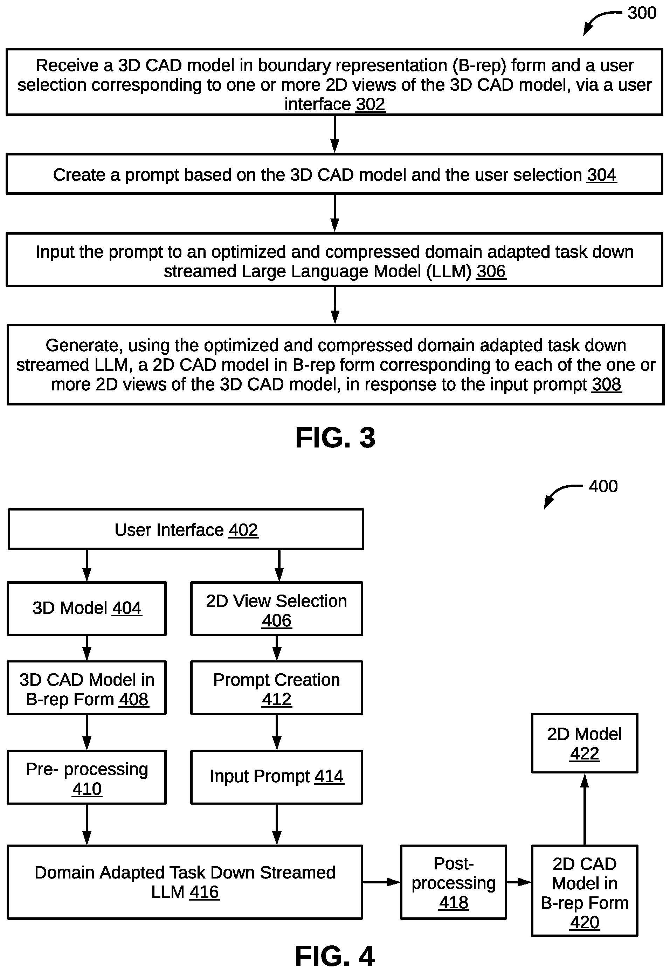

Referring now to FIG. 3, an exemplary process 300 for generating 2D views of 3D CAD models is depicted via a flowchart, in accordance with some embodiments of the present disclosure. FIG. 3 is explained in conjunction with FIGS. 1 and 2. The process 300 may be implemented by the computing device 102 of the system 100. The process 300 may include receiving, by a receiving module (such as the receiving module 202), a 3D CAD model in B-rep form and a user selection corresponding to one or more 2D views of the 3D CAD model, via a user interface (such as the user interface 110), at step 302. It should be the noted that the input may be received. Further, the process 300 may include creating, by a prompt creating module (such as the prompt creating module 204), a prompt based on the 3D CAD model and the user selection, at step 304. It should be noted that the prompt may include the 3D CAD model and predefined instructions corresponding to the one or more 2D views to be generated. The predefined instructions may be retrieved from a database (such as the database 214).

Further the process 300 may include inputting, by a prompt inputting module (such as the prompt inputting module 206) and through an LLM module (such as the LLM module 212), the prompt along with other necessary LLM hyperparameters (such as temperature, top k value, top p value, maximum tokens, frequency penalty, etc.) to an optimized and compressed domain adapted task down streamed LLM, at step 306. It should be noted that the optimized and compressed domain adapted task down streamed LLM is obtained through multi-stage pre-training of a foundation LLM. The multi-stage pre-training may include multiples stages of training (or pre-training). At each of the multiple stages, the multi-stage pre-training may include preprocessing, by a training module (such as the training module 210), a training data corpus for each stage of the multi-stage pre-training, using a set of preprocessing techniques. The training data corpus may be different at each stage. The set of preprocessing techniques may include data deduplication, data cleaning, data decontamination, PII removal, data quality enhancement, bias reduction, and toxicity reduction. Further, the multi-stage pre-training may include performing, by the training module, tokenization of the training data corpus using a tokenization technique, to obtain a tokenized training data corpus. Further, the multi-stage pre-training may include transforming the tokenized training data corpus to a plurality of packed token sequences.

At a first stage of the multi-stage pre-training, the process 300 may include training (herein also referred to as "pre-training"), by the training module, the foundation LLM based on an unsupervised training technique using a first stage training data corpus (i.e., a plurality of packed token sequences of the first stage training data corpus) to obtain a pre-trained LLM, through a predefined training technique and a predefined training objective based on an architecture of the foundation LLM. The first stage training data corpus may include data associated with a mechanical engineering domain. By way of an example, sources of the first stage training data corpus may include, but may not be limited to, books (from public repositories or copyrighted repositories), journals and/or articles (from Arxiv^{®}, domain specific database, news, blog articles, etc.), websites (such as Reddit^{®}, Wikipedia^{®}, common crawl, stack exchange, etc.), code (obtained from Github^{®}, stack overflow, etc.), official documents (such as patents, manuals, government publications, etc.), and the like. It should be noted that the architecture of the foundation LLM may be one of an encoder-decoder architecture, an encoder only architecture, a decoder only architecture, or the like.

In an embodiment, when the architecture of the foundation LLM is the encoder-decoder architecture, the predefined training technique is based on sequence-to-sequence masked language modelling and the predefined training objective is to sequentially predict masked tokens. In another embodiment, when the architecture of the foundation LLM is the encoder only architecture, the predefined training technique is based on masked language modelling and the predefined training objective is to predict a next token by utilizing unmasked tokens. Alternatively, when the architecture of the foundation LLM is the decoder only architecture, the predefined training technique is based on probability language modelling and the predefined training objective is to predict a next token auto-regressively.

At a second stage of the multi-stage pre-training, the process 300 may include training, by the training module, the pre-trained LLM based on the unsupervised training technique using a second stage training data corpus (i.e., a plurality of packed token sequences of the second stage training data corpus) to obtain a domain adapted LLM. The second stage training data corpus may include data associated with B-rep. In an embodiment, the second stage training data corpus may be obtained from the first stage training data corpus by filtering only the data associated with B-rep from the first stage training data corpus. At a third stage of the multi-stage pre-training, the process 300 may include training, by the training module, the domain adapted LLM using a third stage training data corpus (i.e., a plurality of packed token sequences of the third stage training data corpus) to obtain a domain adapted task down streamed LLM using a supervised fine-tuning technique. The third stage training data corpus may include labelled data including 3D CAD models mapped with associated 2D views of the 3D CAD models.

In some embodiments, the multi-stage pre-training may include modifying, by the training module, a number of layers in the foundation LLM during the multi-stage training based on one or more evaluation metrics corresponding to LLM performance.

Further, the process 300 may include generating, by a 2D view generating module (such as the 2D view generating module 208) and through the LLM module, a 2D CAD model in B-rep form corresponding to each of the one or more 2D views of the 3D CAD model, at step 308. It should be noted that the 2D CAD model is generated using the optimized and compressed domain adapted task down streamed LLM.

Referring now to FIG. 4, a detailed exemplary process 400 for generating 2D views of 3D CAD models is depicted via a flowchart, in accordance with some embodiments of the present disclosure. Through a user interface 402 (analogous to the user interface 110), the user may provide a 3D model 404 and a 2D view selection 406 of one or more 2D views corresponding to the 3D model 404. The 3D model 404 may be obtained as a 3D CAD model in B-rep form 408. In other words, the 3D CAD model in B-rep form 408 may be a data file that includes the 3D model 404 represented in the B-rep data format. Further, the process 400 may include a step 410 of pre-processing, by the receiving module 202, the 3D CAD model in B-rep form 408. Further, one or more pre-processing techniques may be applied on the 3D CAD model in B-rep form 408. Upon pre-processing, the 3D CAD model in B-rep form 408 may be converted into a plurality of token sequences.

Additionally, the process 400 may include a step 412 of prompt creation based on the 2D view selection 406 to create an input prompt 414. Further, the LLM unit 212 may receive the pre-processed 3D CAD model in B-rep form 408 from the receiving module 202, and may receive the input prompt 414 from the prompt inputting module 206. The input prompt 414 may include the 2D view selection 406 (i.e., a user selection corresponding to one or more 2D views of the 3D CAD model in B-rep form 408) and predefined instructions corresponding to the one or more 2D views to be generated. The LLM unit 212 may then input the input prompt 414 to a domain adapted task down streamed LLM 416. In response to the input prompt 414, the domain adapted task down streamed LLM 416 may generate B-rep data files corresponding to the one or more 2D views of the 3D CAD model in B-rep form 408.

Further, the process 400 may include a step 418 of post-processing the B-rep data files generated by the domain adapted task down streamed LLM 416. Through post-processing, a 2D CAD model in B-rep form 420 may be obtained corresponding to each of the one or more 2D views of the 3D model 404. Further, a 2D model 422 may be visualized based on the 2D CAD model in B-rep form 420.

Referring now to FIG. 5, an exemplary process 500 for multi-stage pre-training of a foundation LLM 502 is depicted via a flowchart, in accordance with some embodiments of the present disclosure. It should be noted that the foundation LLM 502 may be any state of the art LLM. The process 500 may include a first stage 504, a second stage 506, and a third stage 508. At the first stage 504, a first stage training data corpus may be obtained from a first set of data sources 510. The first stage training data corpus may include data associated with a mechanical engineering domain. By way of an example, the first set of data sources 510 may include, but may not be limited to, books (from public repositories or copyrighted repositories), journals and/or articles (from Arxiv^{®}, domain specific database, news, blog articles, etc.), websites (such as Reddit^{®}, Wikipedia^{®}, common crawl, stack exchange, etc.), code (obtained from Github^{®}, stack overflow, etc.), official documents (such as patents, manuals, government publications, etc.), and like.

The first stage 504 may further include a step 512 of performing data cleaning and preprocessing on the first stage training data corpus. Through the data cleaning and preprocessing, the first stage training data corpus may be tokenized and is transformed into a plurality of packed token sequences corresponding to the first stage training data corpus. Further, the first stage 504 may include a step 514 of continual pre-training of the foundation LLM 502 to obtain a pre-trained model 516 (i.e., pre-trained LLM). The continual pre-training may ensure that the foundation LLM 502 acquires the generic knowledge based on the first stage training data corpus. Through the continual pre-training, the foundation LLM 502 may adapt new knowledge without losing previously acquired (or learnt) knowledge. In other words, the pre-trained model 516 is predominantly analogous to the foundation model 502 that can work as a Next Word Predictor (NWP). It is worth noting that the pre-trained model 516 understands mechanical domain effectively and can be leveraged for other tasks.

Further, the pre-trained model 516 is subjected to the second stage 506 of the multi-stage pre-training process 500. At the second stage 506, a second stage training data corpus may be obtained from a second set of data sources 518. The second stage training data corpus may include data associated with B-rep. By way of an example, the second set of data sources 518 may include, but may not be limited to, B-rep data contained in books (from public repositories or copyrighted repositories), journals and/or articles (from Arxiv^{®}, domain specific database, news, blog articles, etc.), websites (such as Reddit^{®}, Wikipedia^{®}, common crawl, stack exchange, etc.), code (obtained from Github^{®}, stack overflow, etc.), official documents (such as patents, manuals, government publications, etc.), and like.

The second stage 506 may further include a step 520 of performing data cleaning and preprocessing on the second stage training data corpus. Through the data cleaning and preprocessing, the second stage training data corpus may be tokenized and is transformed into a plurality of packed token sequences corresponding to the second stage training data corpus. Further, the second stage 506 may include a step 522 of domain adaptive pre-training of the pre-trained model 516 to obtain a domain adapted model 524 (i.e., domain adapted LLM). The domain adaptive pre-training may be based on an unsupervised training technique. In an embodiment, the second stage 506 can be interchanged for any other downstream activity that demands fundamental mechanical domain understanding (for example, but not limited to, question answering, summarization, content generation, knowledge discovery, and/or reasoning related to mechanical domain).

The domain adaptive pre-training may ensure that the pre-trained LLM 516 acquires the domain knowledge based on the second stage training data corpus. Specifically, the B-rep data (such as CAD model files in B-rep form). Through domain adaptive pre-training, the pre-trained model 516 may adapt new knowledge without losing the previous one. In other words, the domain adapted model 524 is predominantly analogous to the foundation model 502 that can work as an NWP. It is worth noting that the domain adapted model 524 understands B-rep data effectively and can be leveraged for other tasks.

Further, the domain adapted model 524 is subjected to the third stage 508 of the multi-stage pre-training process 500. At the third stage 508, a third stage training data corpus may be obtained from a third set of data sources 526. The third stage training data corpus may include labelled data including 3D CAD models mapped with associated 2D views of the 3D CAD models. Thus, the third stage training data corpus may be a labelled dataset that may be used for supervised learning. By way of an example, the third stage training data corpus may include a 3D CAD model in B-rep form of a cubical object and a set of a 2D CAD model including one or more 2D views corresponding to the cubical object (such as a top view, a bottom view, and a side view).

The third stage 508 may further include a step 528 of performing B-rep preprocessing on the third stage training data corpus to obtain a pre-processed third stage training data corpus. Further, the third stage 508 may include a step 530 of supervised fine-tuning of the domain adapted model 524 to obtain a domain adapted task down streamed model 532 (i.e., domain adapted task down streamed LLM). The continual supervised fine-tuning may be based on a supervised training technique. In an embodiment, the third stage 508 can be interchanged for any other downstream activity that demands fundamental mechanical domain understanding. In an additional embodiment, the third stage 508 can be interchanged for any other downstream activity involving B-rep.

The supervised fine-tuning may ensure that the domain adapted model 524 may acquire the task-specific knowledge of 3D to 2D conversion of 3D CAD models in B-rep form based on the third stage training data corpus. Through the supervised fine-tuning, the domain adapted task down streamed model 532 may adapt the new knowledge without losing the previous one and may effectively handle issues in LLM such as catastrophic forgetting, hallucinations, etc. Further, the process 500 may include a step 534 of model optimization of the domain adapted task down streamed model 532 to obtain an optimized and compressed domain adapted task down streamed model 536 (i.e., optimized and compressed domain adapted task down streamed LLM). The model optimization may include applying a set of pruning and quantization techniques for efficient computing. The model optimization may be performed to adjust the computational resource usage of the domain adapted task down streamed model 532 for optimal execution on a wide range of user devices (such as edge device, PC, cloud, etc.).

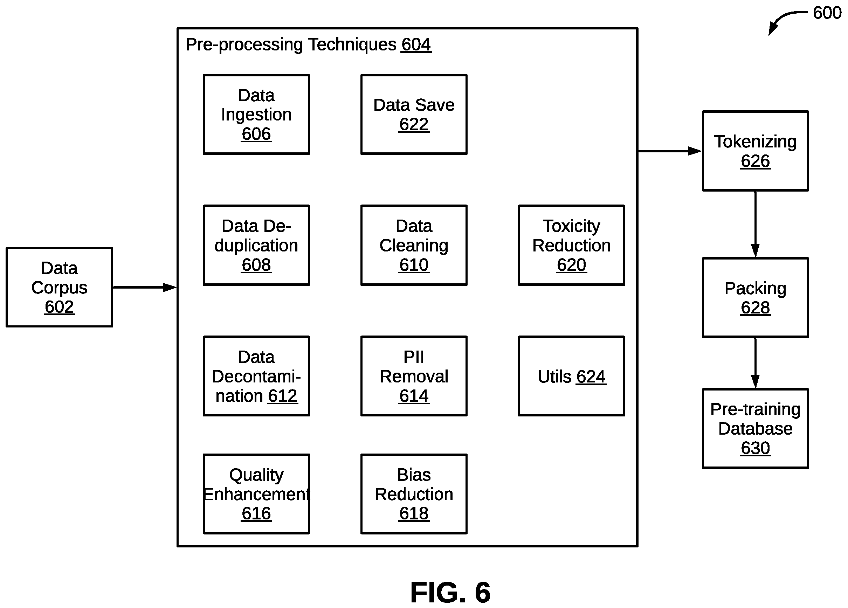

Referring now to FIG. 6, an exemplary process 600 for preprocessing a training data corpus 602 is illustrated, in accordance with some embodiments of the present disclosure. The training data corpus 602 may be a first stage training data corpus, a second stage training data corpus, or a third stage training data corpus. The process 600 may include pre-processing the training data corpus 602 using a set of preprocessing techniques 604 to obtain a preprocessed training data corpus. By way of an example, the set of preprocessing techniques 604 may include, but may not be limited to, data ingestion 606, data deduplication 608, data cleaning 610, data decontamination 612, PII removal 614, data quality enhancement 616, bias reduction 618, toxicity reduction 620, data save 622, and utils 624. The process 600 may further include a step 626 of tokenizing the preprocessed training data corpus using a tokenization technique, to obtain a tokenized training data corpus. The process 600 may further include a step 628 of packing the tokenized training data corpus to obtain a plurality of packed token sequences. Further, the process 600 includes storing the plurality of packed token sequences in a pre-training database 630.

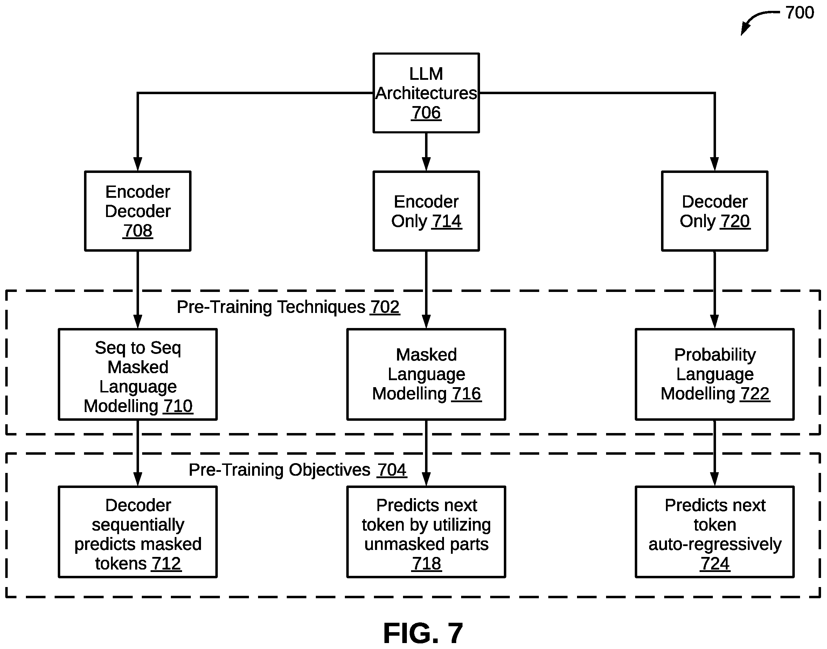

Referring now to FIG. 7, determination of pre-training techniques 702 and pre-training objectives 704 based on LLM architectures 706 is illustrated schematically, in accordance with some embodiments of the present disclosure. In an embodiment, when the architecture of the foundation LLM (such as the foundation LLM 502) is the encoder-decoder architecture 708, the predefined training technique is based on sequence-to-sequence masked language modelling 710 and the predefined training objective is to sequentially predict masked tokens 712. The encoder-decoder architecture 708 works upon receiving an input sequence (for example, 3D CAD model in B-rep form) processing through an encoder, and further generating an output sequence (for example, 2D CAD model in B-rep form) using a decoder.

In an embodiment, when the architecture of the foundation LLM is the encoder only architecture 714, the predefined training technique is based on masked language modelling 716 and the predefined training objective is to predict a next token by utilizing unmasked tokens 718. The encoder only architecture 714 solely focuses on understanding the input sequence (for example, understanding the features of 3D CAD model in B-rep form).

In an embodiment, when the architecture of the foundation LLM is the decoder only architecture 720, the predefined training technique is based on probability language modelling 722 and the predefined training objective is to predict a next token auto-regressively 724. The decoder only architecture 720 solely focuses on generating the output sequence (for example, generating the 2D CAD model in B-rep form).

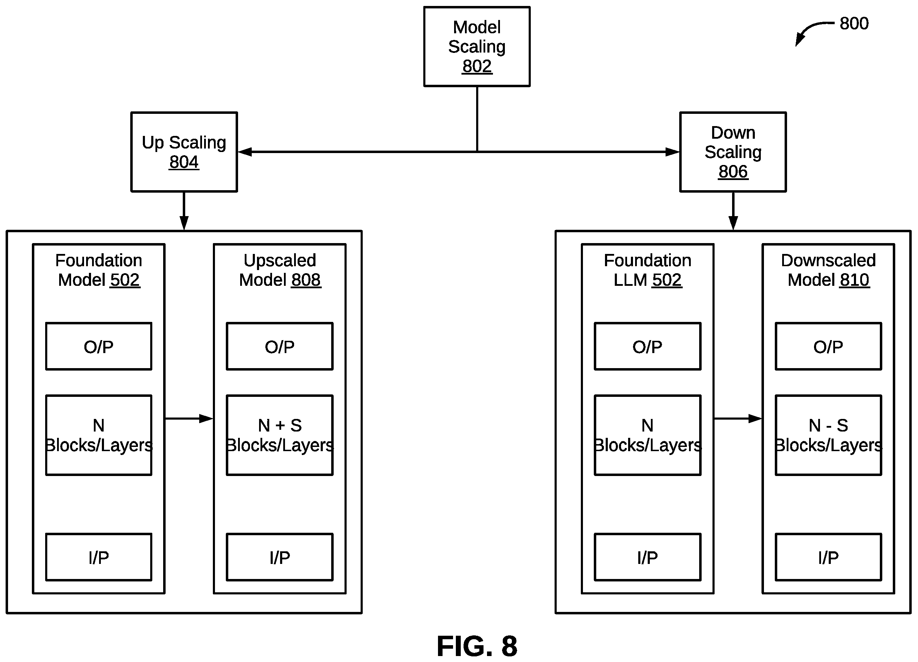

Referring now to FIG. 8, an exemplary process 800 of model scaling of a foundation LLM (such as the foundation model 502) is depicted via a flowchart, in accordance with some embodiments of the present disclosure. The process 800 may be initiated at step 802. The process 800 may include modifying a number of layers in the foundation model 502 during the multi-stage training based on one or more evaluation metrics corresponding to LLM performance (such as perplexity, accuracy, cross-entropy, human evaluation, bias and fairness, hallucination index, toxicity, relevance, response completeness and conciseness, etc.). Modification may include addition or subtraction of layers in the foundation model 502. The process 800 may include a step 804 of up scaling and a step 806 of down scaling. It should be noted that one of the steps 804 or 806 may be performed to perform model scaling of the foundation model 502.

The step 804 of up scaling may include increasing the number of layers of the foundation model 502 during the multi-stage training based, to obtain an upscaled model 808. By way of an example, the foundation model 502 may include an output (O/P) layer, N number of blocks or layers, and an input (I/P) layer. Based on designer need determined from the evaluation metrics, S number of blocks or layers may be added to the N layers in the foundation model 502. Thus, the up scaled model 808 may have a total of N+S number of blocks or layers. The goal of up scaling may be to enhance the ability of the foundation LLM 502 to learn the complex 3D designs.

The step 806 of down scaling may include decreasing the number of layers of the foundation model 502 during the multi-stage pre-training, to obtain a downscaled model 810. the foundation model 502 may include an output (O/P) layer, N number of blocks or layers, and an input (I/P) layer. S number of blocks or layers may be subtracted from the N layers in the foundation model 502. Thus, the down scaled model 810 may have a total of N-S number of blocks or layers. The goal of down scaling may be to enhance the ability of the foundation model 502 to work faster, use less resources along with maintaining performance parameters.

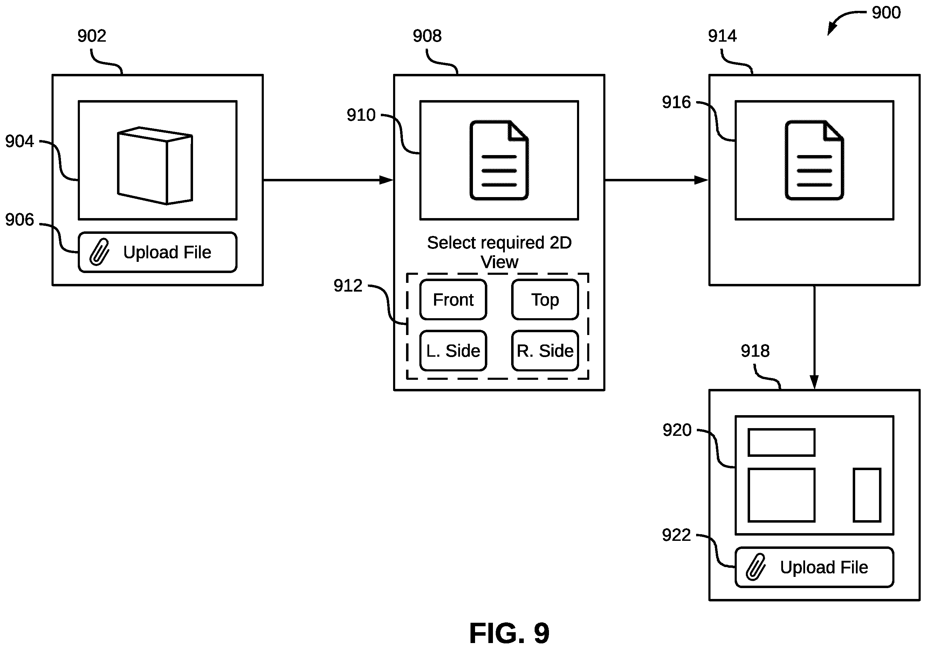

Referring now to FIG. 9, an exemplary process 900 for generating 2D views of 3D CAD models is schematically illustrated, in accordance with some embodiments of the present disclosure. A first Graphical User Interface (GUI) 902 may be presented on the display 108 of the system 100. The first GUI 902 may allow the user to browse a file corresponding to a 3D CAD model in B-rep form. Once the user selects the file, a visual representation 904 of the 3D CAD model in B-rep form may be displayed. The first GUI 902 may also include a button 906 to allow the user to upload the file.

When the user uploads the file through the first GUI 902, a second GUI 908 may be presented on the display 108 of the system 100. The second GUI 908 may provide text contents 910 of the file corresponding to the 3D CAD model. In an embodiment, the text contents 910 may not be displayed on the second GUI 908 and may only be processed in the backend. Further, the second GUI 908 may include a section 912 including various options corresponding to 2D views to be generated corresponding to the 3D CAD model in B-rep form. For example, the various options may include 'front view', 'top view', 'left side view', and 'right side view'. The user may select one or more options. For example, the user selects 'front view', 'top view', and 'left side view' from the displayed options in the section 912 and provides the user selected 2D view options through the second GUI 908.

Once the user provides the user selected 2D view options through the second GUI 908, a third GUI 914 may be presented on the display 108 of the system 100. The third GUI 914 may provide text contents 916 of the file of a 2D CAD model in B-rep form corresponding to each of the user-selected 2D views of the 3D CAD model. The file of the 2D CAD model in B-rep form may be generated through the optimized and compressed domain adapted task down streamed LLM. In an embodiment, the text contents 910 may not be displayed on the second GUI 908 and may only be processed by the optimized and compressed domain adapted task down streamed LLM in the backend.

Further, a fourth GUI 918 may be presented on the display 108 of the system 100. A visual representation 920 of the 2D CAD model in B-rep form corresponding to each of the user-selected 2D views of the 3D CAD model may be displayed on the fourth GUI 918. It should be noted that the visual representation of the 2D CAD model in B-rep form may be based on the file corresponding to 2D CAD model in B-rep form. The fourth GUI 920 may also include a button 906 to allow the user to upload the file.

As will be also appreciated, the above-described techniques may take the form of computer or controller implemented processes and apparatuses for practicing those processes. The disclosure can also be embodied in the form of computer program code containing instructions embodied in tangible media, such as floppy diskettes, solid state drives, CD-ROMs, hard drives, or any other computer-readable storage medium, wherein, when the computer program code is loaded into and executed by a computer or controller, the computer becomes an apparatus for practicing the invention. The disclosure may also be embodied in the form of computer program code or signal, for example, whether stored in a storage medium, loaded into and/or executed by a computer or controller, or transmitted over some transmission medium, such as over electrical wiring or cabling, through fiber optics, or via electromagnetic radiation, wherein, when the computer program code is loaded into and executed by a computer, the computer becomes an apparatus for practicing the invention. When implemented on a general-purpose microprocessor, the computer program code segments configure the microprocessor to create specific logic circuits.

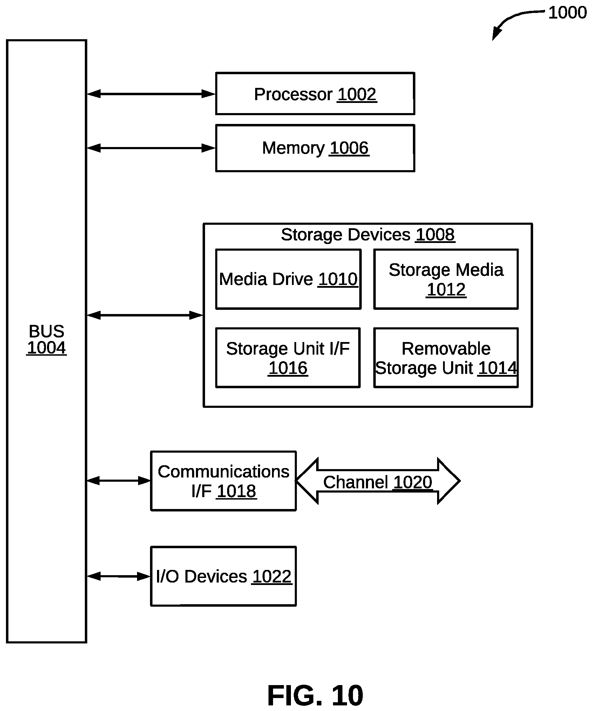

The disclosed methods and systems may be implemented on a conventional or a general-purpose computer system, such as a personal computer (PC) or server computer. Referring now to FIG. 10, an exemplary computing system 1000 that may be employed to implement processing functionality for various embodiments (e.g., as a SIMD device, client device, server device, one or more processors, or the like) is illustrated. Those skilled in the relevant art will also recognize how to implement the invention using other computer systems or architectures. The computing system 1000 may represent, for example, a user device such as a desktop, a laptop, a mobile phone, personal entertainment device, DVR, and so on, or any other type of special or general-purpose computing device as may be desirable or appropriate for a given application or environment. The computing system 1000 may include one or more processors, such as a processor 1002 that may be implemented using a general or special purpose processing engine such as, for example, a microprocessor, microcontroller or other control logic. In this example, the processor 1002 is connected to a bus 1004 or other communication medium. In some embodiments, the processor 1002 may be an Artificial Intelligence (AI) processor, which may be implemented as a Tensor Processing Unit (TPU), or a graphical processor unit, or a custom programmable solution Field-Programmable Gate Array (FPGA).

The computing system 1000 may also include a memory 1006 (main memory), for example, Random Access Memory (RAM) or other dynamic memory, for storing information and instructions to be executed by the processor 1002. The memory 1006 also may be used for storing temporary variables or other intermediate information during execution of instructions to be executed by the processor 1002. The computing system 1000 may likewise include a read only memory ("ROM") or other static storage device coupled to bus 1004 for storing static information and instructions for the processor 1002.

The computing system 1000 may also include a storage devices 1008, which may include, for example, a media drive 1010 and a removable storage interface. The media drive 1010 may include a drive or other mechanism to support fixed or removable storage media, such as a hard disk drive, a floppy disk drive, a magnetic tape drive, an SD card port, a USB port, a micro-USB, an optical disk drive, a CD or DVD drive (R or RW), or other removable or fixed media drive. A storage media 1012 may include, for example, a hard disk, magnetic tape, flash drive, or other fixed or removable medium that is read by and written to by the media drive 1010. As these examples illustrate, the storage media 1012 may include a computer-readable storage medium having stored there in particular computer software or data.

In alternative embodiments, the storage devices 1008 may include other similar instrumentalities for allowing computer programs or other instructions or data to be loaded into the computing system 1000. Such instrumentalities may include, for example, a removable storage unit 1014 and a storage unit interface 1016, such as a program cartridge and cartridge interface, a removable memory (for example, a flash memory or other removable memory module) and memory slot, and other removable storage units and interfaces that allow software and data to be transferred from the removable storage unit 1014 to the computing system 1000.

The computing system 1000 may also include a communications interface 1018. The communications interface 1018 may be used to allow software and data to be transferred between the computing system 1000 and external devices. Examples of the communications interface 1018 may include a network interface (such as an Ethernet or other NIC card), a communications port (such as for example, a USB port, a micro-USB port), Near field Communication (NFC), etc. Software and data transferred via the communications interface 1018 are in the form of signals which may be electronic, electromagnetic, optical, or other signals capable of being received by the communications interface 1018. These signals are provided to the communications interface 1018 via a channel 1020. The channel 1020 may carry signals and may be implemented using a wireless medium, wire or cable, fiber optics, or another communications medium. Some examples of the channel 1020 may include a phone line, a cellular phone link, an RF link, a Bluetooth link, a network interface, a local or wide area network, and other communications channels.

The computing system 1000 may further include Input/Output (I/O) devices 1022. Examples may include, but are not limited to a display, keypad, microphone, audio speakers, vibrating motor, LED lights, etc. The I/O devices 1022 may receive input from a user and also display an output of the computation performed by the processor 1002. In this document, the terms "computer program product" and "computer-readable medium" may be used generally to refer to media such as, for example, the memory 1006, the storage devices 1008, the removable storage unit 1014, or signal(s) on the channel 1020. These and other forms of computer-readable media may be involved in providing one or more sequences of one or more instructions to the processor 1002 for execution. Such instructions, generally referred to as "computer program code" (which may be grouped in the form of computer programs or other groupings), when executed, enable the computing system 1000 to perform features or functions of embodiments of the present invention.

In an embodiment where the elements are implemented using software, the software may be stored in a computer-readable medium and loaded into the computing system 1000 using, for example, the removable storage unit 1014, the media drive 1010 or the communications interface 1018. The control logic (in this example, software instructions or computer program code), when executed by the processor 1002, causes the processor 1002 to perform the functions of the invention as described herein.

Thus, the disclosed method and system try to overcome the technical problem of generating 2D views of a 3D CAD model. The method and system may provide a solution for the automated generation of the 2D views of the 3D CAD model without the requirement of the user. The method and system are developed using the boundary representation (B-rep) of the 3D models and the boundary representation (B-rep) of the 2D models. Utilizing B-rep may make the solution robust and adaptable. Further the method and system may reduce the design time of the users by approximately 50%.

In light of the above-mentioned advantages and the technical advancements provided by the disclosed method and system, the claimed steps as discussed above are not routine, conventional, or well understood in the art, as the claimed steps enable the following solutions to the existing problems in conventional technologies. Further, the claimed steps clearly bring an improvement in the functioning of the device itself as the claimed steps provide a technical solution to a technical problem.

The specification has described method and system for generating and rendering a customized dashboard. The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope and spirit of the disclosed embodiments.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope and spirit of disclosed embodiments being indicated by the following claims.

## Claims

1. A method for generating 2-Dimensional (2D) views of 3-Dimensional (3D) Computer-Aided Design (CAD) models, the method comprising:
receiving, by a computing device, a 3D CAD model in boundary representation (B-rep) form and a user selection corresponding to one or more 2D views of the 3D CAD model, via a user interface;
creating, by the computing device, a prompt based on the 3D CAD model and the user selection, wherein the prompt comprises the 3D CAD model and predefined instructions corresponding to the one or more 2D views to be generated;
inputting, by the computing device, the prompt to an optimized and compressed domain adapted task down streamed Large Language Model (LLM), wherein the optimized and compressed domain adapted task down streamed LLM is obtained through multi-stage pre-training of a foundation LLM; and
generating, by the computing device using the optimized and compressed domain adapted task down streamed LLM, a 2D CAD model in B-rep form corresponding to each of the one or more 2D views of the 3D CAD model, in response to the input prompt.

2. The method as claimed in claim 1, wherein the multi-stage pre-training of the foundation LLM comprises:
preprocessing a training data corpus for each stage of the multi-stage pre-training, using a set of preprocessing techniques, wherein the set of preprocessing techniques comprises data deduplication, data cleaning, data decontamination, Personally Identifiable Information (PII) removal, data quality enhancement, bias reduction, and toxicity reduction;
upon preprocessing, performing tokenization of the training data corpus using a tokenization technique, to obtain a tokenized training data corpus; and
transforming the tokenized training data corpus to a plurality of packed token sequences.

3. The method as claimed in claim 2, wherein the multi-stage pre-training of the foundation LLM further comprises:
training the foundation LLM based on an unsupervised training technique using a first stage training data corpus to obtain a pre-trained LLM, through a predefined training technique and a predefined training objective based on an architecture of the foundation LLM, wherein the first stage training data corpus comprises data associated with a mechanical engineering domain, and wherein the architecture of the foundation LLM is one of an encoder-decoder architecture, an encoder only architecture, or a decoder only architecture.

4. The method as claimed in claim 3, wherein the multi-stage pre-training of the foundation LLM further comprises:
training the pre-trained LLM based on the unsupervised training technique using a second stage training data corpus to obtain a domain adapted LLM, wherein the second stage training data corpus comprises data associated with B-rep.

5. The method as claimed in claim 4, wherein the multi-stage pre-training of the foundation LLM further comprises:
training the domain adapted LLM using a third stage training data corpus to obtain a domain adapted task down streamed LLM using a supervised fine-tuning technique, wherein the third stage training data corpus comprises labelled data comprising 3D CAD models mapped with associated 2D views of the 3D CAD models.

6. The method as claimed in claim 5, wherein:
when the architecture of the foundation LLM is the encoder-decoder architecture, the predefined training technique is based on sequence-to-sequence masked language modelling and the predefined training objective is to sequentially predict masked tokens;
when the architecture of the foundation LLM is the encoder only architecture, the predefined training technique is based on masked language modelling and the predefined training objective is to predict a next token by utilizing unmasked tokens;
when the architecture of the foundation LLM is the decoder only architecture, the predefined training technique is based on probability language modelling and the predefined training objective is to predict a next token auto-regressively; and
the multi-stage pre-training of the foundation LLM further comprises modifying a number of layers in the foundation LLM during the multi-stage training based on one or more evaluation metrics corresponding to LLM performance.

7. A system for generating 2D views of 3D CAD models, the system comprising:
a processor; and
a computer-readable medium communicatively coupled to the processor, wherein the computer-readable medium stores processor-executable instructions, which when executed by the processor, cause the processor to:
receive a 3D CAD model in boundary representation (B-rep) form and a user selection corresponding to one or more 2D views of the 3D CAD model, via a user interface;
create a prompt based on the 3D CAD model and the user selection, wherein the prompt comprises the 3D CAD model and predefined instructions corresponding to the one or more 2D views to be generated;
input the prompt to an optimized and compressed domain adapted task down streamed Large Language Model (LLM), wherein the optimized and compressed domain adapted task down streamed LLM is obtained through multi-stage pre-training of a foundation LLM; and
generate using the optimized and compressed domain adapted task down streamed LLM, a 2D CAD model in B-rep form corresponding to each of the one or more 2D views of the 3D CAD model, in response to the input prompt.

8. The system as claimed in claim 7, wherein for the multi-stage pre-training of the foundation LLM, the processor-executable instructions, on execution, cause the processor to:
preprocess a training data corpus for each stage of the multi-stage pre-training, using a set of preprocessing techniques, wherein the set of preprocessing techniques comprises data deduplication, data cleaning, data decontamination, Personally Identifiable Information (PII) removal, data quality enhancement, bias reduction, and toxicity reduction;
perform tokenization of the training data corpus using a tokenization technique, to obtain a tokenized training data corpus; and
transform the tokenized training data corpus to a plurality of packed token sequences.

9. The system as claimed in claim 8, wherein for the multi-stage pre-training of the foundation LLM, the processor-executable instructions, on execution, further cause the processor to:
train the foundation LLM based on an unsupervised training technique using a first stage training data corpus to obtain a pre-trained LLM, through a predefined training technique and a predefined training objective based on an architecture of the foundation LLM, wherein the first stage training data corpus comprises data associated with a mechanical engineering domain, and wherein the architecture of the foundation LLM is one of an encoder-decoder architecture, an encoder only architecture, or a decoder only architecture.

10. The system as claimed in claim 9, wherein for the multi-stage pre-training of the foundation LLM, the processor-executable instructions, on execution, further cause the processor to:
train the pre-trained LLM based on the unsupervised training technique using a second stage training data corpus to obtain a domain adapted LLM, wherein the second stage training data corpus comprises data associated with B-rep.

11. The system as claimed in claim 10, wherein for the multi-stage pre-training of the foundation LLM, the processor-executable instructions, on execution, further cause the processor to:
train the domain adapted LLM using a third stage training data corpus to obtain a domain adapted task down streamed LLM using a supervised fine-tuning technique, wherein the third stage training data corpus comprises labelled data comprising 3D CAD models mapped with associated 2D views of the 3D CAD models.
